# FASCICULE DE BREVET EUROPEEN

(11) **EP 2 585 539 B1**
(45) Date de publication et mention de la délivrance du brevet: **02.11.2016**
(21) Numéro de dépôt: 11727683.2
(22) Date de dépôt: 21.06.2011
(51) Int. Cl.: C08L 77/06, C08K 3/00, C08K 5/00, C08K 7/02, C08K 5/5313, C08K 13/04

(54) **COMPOSITION POLYAMIDE POUR COMPOSANTS MONTES EN SURFACE**
POLYAMIDZUSAMMENSETZUNG FÜR OBERFLÄCHENMONTIERTE ZUSAMMENSETZUNGEN
POLYAMIDE COMPOSITION FOR SURFACE-MOUNTED COMPONENTS

(30) Priorité: 22.06.2010 FR 1054929
(43) Date de publication de la demande: 01.05.2013
(73) Titulaire: Rhodia Operations, 93306 Aubervilliers (FR)
(72) Inventeur: JEOL, Stéphane, F-69006 Lyon (FR)
(74) Mandataire: Benvenuti, Federica
(86) Numéro de dépôt international: PCT/EP2011/060293
(87) Numéro de publication internationale: WO 2011/161082

(56) Documents cités:
- WO-A1-2010/034805
- WO-A2-2010/034803
- US-A- 6 140 459

## Description

La présente invention a pour objet des composants destinés à être montés en surface (CMS) au moins obtenu à partir d'une composition comprenant au moins : A) un polyamide semi-aromatique modifié par un composé hydroxyaromatique ; B) des charges de renfort ; et C) un agent ignifugeant. Ces compositions présentent de nombreux avantages liés à leurs utilisations dans des procédés brasage par refusion sans plomb, notamment une bonne stabilité dimensionnelle et une résistance au cloquage lors de l'utilisation des articles réalisés à partir de ces compositions.

### ART ANTERIEUR

Les composants montés en surface (CMS) sont des composants électroniques destinés a être liés sur des cartes de circuits imprimés par une technique appelée « Surface Mount Technology » (SMT). Cette technique consiste à braser les composants d'une carte à sa surface par assemblage au moyen d'un liant, ou métal d'apport, lui-même composé d'un autre métal que les pièces à assembler. On procède généralement à un brasage par refusion ou « Reflow Soldering » qui est un procédé dans lequel une crème ou pâte à braser est utilisée pour préalablement lier des composants électriques à leur support. L'assemblage obtenu est alors soumis à de fortes températures : la chaleur fait fondre les constituants de la crème à braser, liant les composants électroniques à leur support de façon permanente. C'est l'une des méthodes les plus utilisées pour relier des composants électroniques à des cartes de circuits imprimés.

Un brasage de haute qualité nécessite d'identifier le profil de température optimal pour la fusion de la crème à braser et de pouvoir le reproduire au cours du temps. Chaque joint de brasure d'une carte doit être chauffé de la même manière, pour obtenir la qualité de brasure désirée. La nature de la source de chaleur n'importe pas, cependant la chaleur doit être appliquée au joint de brasure de façon contrôlée. Les montées et descentes de température doivent être compatibles avec la crème à braser et les composants plastiques.

Une crème à braser est une suspension de poudre métallique dans un liquide visqueux appelé flux. Les éléments d'alliages de métaux constitutifs ont la particularité d'atteindre la fusion à une température inférieure à celles des composants à souder. Les billes d'alliages métalliques sont de forme sphérique, ce qui contribue à réduire l'oxydation de surface et assurer la formation de joints de bonne qualité avec les particules voisines. Les pâtes sont classées selon la taille des particules par la norme JEDEC J-STD 005. Depuis l'application de la directive européenne 2002/95/CE -RoHS- qui a conduit au bannissement du plomb, chrome hexavalent, mercure, cadmium, PBB et PBDE, l'évolution majeure en cours est le passage de l'industrie électronique au « sans plomb » (ou Lead Free Soldering -LFS). En effet, jusqu'à il y a peu, les brasures étaient réalisées à base d'alliages du type Etain-Plomb (SnPb). L'avantage du plomb était notamment d'abaisser le point de refusion des alliages d'étain. Il existe désormais de nombreux alliages de substitution utilisés dans les crèmes à braser. Les principaux sont les alliages Etain-Argent-Cuivre (SnAgCu), Etain-Argent (SnAg), et Etain-Cuivre (SnCu). Comparativement aux alliages Etain-Plomb, leur température de fusion est nettement supérieure de plusieurs dizaine de degrés, obligeant ainsi à travailler à des températures aux alentours de 240-260°C. Malgré tout, il existe une recherche d'alliages de plus bas point de fusion. En effet, pour les alliages sans plomb, le NEMI (National Electronics Manufacturing Initiative) conseille une température minimum de refusion de 15°C au dessus de la température de fusion de l'alliage. Cette température minimum est nécessaire pour obtenir un étalement suffisant de l'alliage et réaliser les composés intermétalliques dans le joint de soudure. Ces derniers assurent la tenue mécanique de l'assemblage. Le temps pendant lequel le joint de brasure est au-dessus du point de fusion est désigné sous le nom de temps de mouillage. Le temps de mouillage est de 60 à 90 secondes pour la plupart des crèmes sans plomb.

Cette augmentation de température a plusieurs conséquences négatives, notamment sur la tenue thermique des composants qui doivent pouvoir supporter des températures plus élevées et des chocs thermiques plus importants. De même il existe désormais une obligation de gérer de manière plus stricte qu'auparavant les niveaux de sensibilité à l'humidité (Moisture Sensible Level : MSL). En effet, une reprise d'humidité des composants avant l'étape de refusion peut conduire à leur destruction, notamment en cas de stabilité dimensionnelle insuffisante. Emballage sous vide, stockage dans des armoires sèches, régulation du taux d'humidité des ateliers sont autant de nouvelles contraintes à intégrer pour les entreprises. Au surplus lors du procédé reflow soldering, les polymères utilisés dans les composants sont soumis à des températures provoquant des phénomènes de blistering ou défauts de cloquage.

Il est connu de l'art antérieur d'utiliser des composants CMS à base de polymère polyamide résistant à de fortes températures, notamment des polyamides aromatiques ou semi-aromatiques. On peut citer à cet effet les formulations à base des polyamides 66/6T, des polyamides 46, des polyamides 6/6T, des polyamides 6T/4T/46 tels que mentionnés dans la demande WO2009/012936, des polyamides 9T, en présence ou en absence d'agents ignifugeants. Le brevet EP1613698 décrit a cet effet une composition comprenant un polyamide partiellement aromatique et un agent ignifugeant à base de sel d'acide phosphinique ou diphosphinique.

Toutefois, ces formulations présentent des reprises en eau non négligeables pouvant conduire à une stabilité dimensionnelle insuffisante en milieu humide obligeant une gestion stricte des niveaux d'humidité avant et pendant les procédés de brasage par refusion sans plomb.

Il existait ainsi un besoin de mettre au point une composition polyamide permettant d'obtenir de bonnes propriétés ainsi qu'un bon maintien des propriétés lors des procédés de brasage par refusion sans plomb, notamment les propriétés mécaniques, de stabilités dimensionnelles, d'ignifugations et de résistances au blistering.

### INVENTION

La demanderesse vient de mettre en évidence une formulation pour composants CMS combinant d'excellentes propriétés mécaniques, de stabilités dimensionnelles, d'ignifugations et de résistances au blistering.

La présente invention à pour premier objet un composant destiné à être monté en surface (CMS), notamment un composant monté en surface, au moins obtenu à partir d'une composition comprenant au moins A) un polyamide semi-aromatique modifié par un composé hydroxyle aromatique ; B) des charges de renfort ; et C) un agent ignifugeant.

L'invention concerne plus particulièrement des composants électroniques destinés à être montés en surface.

Il apparaît de manière tout à fait surprenante que l'utilisation combinée d'un polyamide modifié par un composé hydroxyle aromatique et des charges de renfort dans une composition polyamide permet d'obtenir une remarquable stabilité dimensionnelle alors même que le polyamide modifié par un composé hydroxyaromatique ne possédait pas en lui-même une bonne stabilité dimensionnelle. Les compositions selon l'invention présentent une excellente stabilité dimensionnelle après le démoulage des articles, avant et après le procédé de brasage, et après une exposition en conditions de température et d'humidité. Les composants lorsqu'ils sont mis en oeuvre dans des procédés de soudage ou de brasage ne présentent pas de phénomènes de blistering ou défauts de cloquage.

Le terme « blistering » correspond à deux phénomènes distincts : blistering aux interfaces des éléments conducteurs et isolants électriques ou blistering au sein de la matière isolante électrique, en l'occurrence ici la composition polymère. Dans la littérature, c'est le premier phénomène qui est majoritairement abordé, alors que le blistering au sein de la matière isolante électrique n'est pas encore bien étudié.

Il vient d'être découvert que l'origine du blistering apparent au sein d'un polymère peut être reliée à l'absorption d'eau dépendante du volume libre disponible entre les chaines du réseau macromoléculaire, la polarité des groupements du polymère et les mouvements moléculaires. Or, il apparait pour des pièces fines de 0,4 mm à 1,6 mm d'épaisseur que la rapide montée en température lors du procédé de refusion ne laisse pas suffisamment de temps à la diffusion totale de l'eau évaporée jusqu'à l'extérieur du polymère. Ceci entraine une pression considérable contre les bords du solide créant alors un blister -ou une cloque. Afin de diminuer le risque de cloquage, il semblait alors important de limiter la présence d'eau au sein du polymère, notamment en diminuant sa reprise en eau. Or, pour ce qui concerne le polyamide, l'utilisation d'additif classiquement utilisé à cet effet comme la résine novolaque ne conduit pas du tout au control du blistering et apparaît au contraire même accentuer le phénomène de blistering. Un tel effet n'a pu être obtenu uniquement en combinant les moyens présentés précédemment.

On entend au sens de l'invention par polyamide semi-aromatique modifié par un composé hydroxyle aromatique, un polyamide obtenu en utilisant des monomères aliphatiques ainsi que des monomères aromatiques, et en outre un composé hydroxyle aromatique.

On utilise préférentiellement un polyamide semi-aromatique dans lequel 5-50 % en moles des monomères utilisés comprennent des groupements aromatique, incluant les composés hydroxyle aromatiques.

Les monomères du polyamide semi-aromatique peuvent notamment être des monomères diacides, notamment aliphatique, cycloaliphatique, arylaliphatique ou aromatique, des monomères diamines, notamment aliphatiques, et/ou des aminoacides ou lactames. Ce sont généralement les monomères classiquement utilisés pour la fabrication de polyamides semi-cristallins, tels que les polyamides aliphatiques, polyamides semi-aromatiques et plus généralement, les polyamides linéaires obtenus par polycondensation entre un diacide saturé aliphatique ou aromatique, et une diamine primaire saturée aromatique ou aliphatique, les polyamides obtenus par condensation d'un lactame, d'un aminoacide ou les polyamides linéaires obtenus par condensation d'un mélange de ces différents monomères. Les monomères des polyamides peuvent éventuellement contenir des insaturations ou des hétéroatomes tels l'oxygène, le soufre, l'azote.

Les acides dicarboxyliques peuvent être choisis parmi l'acide glutarique, l'acide adipique, l'acide pimellique, l'acide subérique, l'acide azélaïque, l'acide sébacique, l'acide dodécanedioïque, l'acide brassilique ; l'acide 1,2-ou 1,3-cyclohexane dicarboxylique ; l'acide 1,2-ou 1,3-phénylène diacétique ; l'acide 1,2-ou 1,3-cylohexane diacétique ; l'acide isophthalique ; l'acide téréphthalique ; l'acide 4,4'-benzophénone dicarboxylique; l'acide 2,5-naphthalène dicarboxylique; et l'acide p-t-butyl isophthalique. Les acides dicarboxyliques préférés sont les acides adipique, téréphtalique et isophtalique.

Les diamines peuvent par exemple être choisies parmi l'hexaméthylène diamine; la 1,4-diaminobutane ; la 1,5-diaminopentane; la 2-méthyl pentaméthylène diamine ; la 2-méthyl hexaméthylène diamine ; la 3-méthyl hexa-méthylène diamine; la 2,5-diméthyl hexaméthylène diamine; la 2,2-diméthylpentaméthylène diamine ; la nonane diamine ; la 1,10-diaminodecane; la 5-méthylnonane diamine; la dodécaméthylène diamine; la 2,2,4-et 2,4,4-triméthyl hexaméthylène diamine; la 2,2,7,7-tétraméthyl octaméthylène diamine; l'isophorone diamine; le diaminodicyclohexyl méthane et les diamines aliphatiques en C2 -C16 qui peuvent être substituées par un ou plusieurs groupements alkyles. Les diamines préférées sont l'hexaméthylène diamine et la 1,4-diaminobutane.

Le polyamide modifié de l'invention peut être obtenu à partir notamment d'un monomère lactame ou un aminoacide, de préférence aliphatique. A titre d'exemple de tels lactames ou aminoacides, on peut citer le caprolactame, l'acide 6-aminohexanoïque, l'acide 5-aminopentanoïque, l'acide 7-aminoheptanoïque, l'acide 11-aminoundécanoïque, le dodécanolactame.

Ces polyamides peuvent notamment être modifiés par des monomères difonctionnels ou monofonctionnels, tels que notamment des diacides ou diamines, monoacides ou monoamines.

Des polyamides selon l'invention peuvent aussi être obtenus par mélange, notamment en fondu, de polyamides avec des monomères modifiant la longueur des chaînes, tels que notamment des diamines, diacides carboxyliques, monoamines et/ou monoacides carboxyliques.

La composition de l'invention peut également comprendre les copolyamides dérivés notamment des polyamides ci-dessus, ou les mélanges de ces polyamides ou (co)polyamides.

On peut également utiliser comme polyamide de haute fluidité un polyamide étoile comprenant des chaînes macromoléculaires étoiles et le cas échéant des chaînes macromoléculaires linéaires.

Le polyamide à structure étoile est un polymère comprenant des chaînes macromoléculaires étoiles, et éventuellement des chaînes macromoléculaires linéaires. Les polymères comprenant de telles chaînes macromoléculaires étoiles sont par exemple décrits dans les documents FR2743077, FR2779730, EP0682057 et EP0832149. Ces composés sont connus pour présenter une fluidité améliorée par rapport à des polyamides linéaires. Les chaînes macromoléculaires étoiles comportent un coeur et au moins trois branches de polyamide. Les branches sont liées au coeur par une liaison covalente, par l'intermédiaire d'un groupement amide ou d'un groupement d'une autre nature. Le coeur est un composé chimique organique ou organométallique, de préférence un composé hydrocarboné comportant éventuellement des hétéroatomes et auquel sont reliées les branches. Les branches sont des chaînes polyamides. Les chaînes polyamides constituant les branches sont de préférence du type de celles obtenues par polymérisation des lactames ou aminoacides, par exemple de type polyamide 6. Le polyamide à structure étoile selon l'invention comprend éventuellement, outre les chaînes étoiles, des chaînes polyamide linéaires. Dans ce cas, le rapport en poids entre la quantité de chaînes étoiles et la somme des quantités de chaînes étoiles et de chaînes linéaires est compris entre 0,5 et 1 bornes incluses. Il est de préférence compris entre 0,6 et 0,9.

On peut notamment utiliser les (co)polyamides choisis dans le groupe comprenant le polyamide 6T, le polyamide 66/6T, le polyamide 61, le polyamide 66/61, le polyamide 6T/6I, le copolyamide 6/6T de différentes compositions molaires ainsi que leurs mélanges.

Les polyamides de l'invention présentent généralement un point de fusion compris entre 150°C et 340°C, et plus particulièrement entre 240 et 340°C pour les procédés qui utilisent les alliages actuels de soudure sans plomb.

La composition selon l'invention présente préférentiellement de 30 à 75 % en poids de polyamide, par rapport au poids total de la composition, préférentiellement de 35 à 60 % en poids.

Le composé hydroxyle aromatique, ou hydroxyaromatique est un composé portant au moins une, notamment une ou deux, fonctions capables de réagir avec les fonctions amines ou acides du polyamide ou des monomères du polyamide. Avantageusement le groupement hydroxyle du composé n'est pas encombré, c'est-à-dire par exemple que les atomes de carbone situés en α de la fonction hydroxyle ne sont de préférence pas substitués par des substituants encombrants, tels que des alkyles ramifiés.

Par « groupement hydroxyle aromatique », on entend une fonction hydroxyle rattachée à un atome de carbone faisant partie d'un cycle aromatique.

Par « composé hydroxyaromatique », on entend un composé organique comportant au moins un groupement hydroxyle aromatique.

Les fonctions du composé hydroxyaromatique pouvant réagir avec les fonctions du polyamide sont notamment les fonctions acide, cétone, amine et aldéhyde. Par « fonction acide » on entend une fonction acide carboxylique ou dérivée, telles que chlorure d'acide, anhydride d'acide, amide, ester.

Par acide carboxylique, on entend les acides carboxyliques et leurs dérivés, tels que les anhydrides d'acide, les chlorures d'acide, les amides ou les esters.

Les groupements hydroxyle aromatique de l'invention ne sont pas considérés comme des fonctions réagissant avec les fonctions acides.

La présente invention concerne notamment un polyamide modifié par un composé contenant au moins un groupement hydroxyle aromatique chimiquement lié à la chaîne polymère, ce polyamide pouvant être obtenu par polymérisation, outre les monomères du polyamide, d'un composé hydroxyaromatique ou par mélange en phase fondue d'un polyamide partiellement ou totalement formé avec un composé hydroxyaromatique, notamment lors d'une extrusion réactive. Le polyamide modifié selon l'invention peut également être obtenu par polycondensation en phase solide ou en phase solvant pour certains polyamides.

Par « chimiquement lié » on entend lié par une liaison covalente. Une fois chimiquement lié à la chaîne polyamide, le composé hydroxyaromatique devient un motif hydroxyaromatique et le polyamide modifié de l'invention est un polyamide contenant des motifs hydroxyaromatiques.

Le composé hydroxyaromatique peut par exemple être représenté par la formule suivante (I) :

**(HO)ₓ-Z-(F)ₙ** **(I)**

dans laquelle :
- Z est un radical hydrocarboné aromatique ou arylaliphatique multivalent, au moins divalent,
- x est compris entre 1 et 10 ;
- F est une fonction acide, aldéhyde, amine, cétone capable de se lier à une fonction acide ou amine des monomères du polyamide, et
- n est compris entre 1 et 5.

Z peut éventuellement comprendre des hétéroatomes, tels que N et O. Z peut par exemple être choisi dans le groupe comprenant : le benzène, le méthyle benzène, le naphtalène, le biphényle, le diphényle éther, le diphényle sulfure, le diphényle sulfone, le ditolyle éther, le xylylène, le diéthyl benzène, ou la pyridine.

Par « radical arylaliphatique » on entend un radical selon lequel au moins une fonction F du composé de formule (I) n'est pas rattachée à ce radical par un atome de carbone faisant partie d'un cycle aromatique.

Avantageusement Z comporte entre 6 et 18 atomes de carbone.

Un composé hydroxyaromatique peut parfaitement contenir plusieurs types de fonctions F de nature différente.

Ce composé est de préférence choisi dans le groupe comprenant : l'acide 2-hydroxytéréphtalique, l'acide 5-hydroxyisophtalique, l'acide 4-hydroxyisophtalique, l'acide 2,5-dihydroxytéréphtalique, l'acide 4-hydroxyphénylacétique ou l'acide gallique, la L-Tyrosine, l'acide 4-hydroxyphénylacétique, le 3,5-diaminophénol, le 5-hydroxy m-xylylène diamine, l'amino-3 phénol, l'amino-3 méthyl-4 phénol, et l'acide hydroxy-3 amino-5 benzoïque.

Dans le cadre de l'invention, des mélanges de différents composés de formule (I) peuvent être mis en oeuvre.

La proportion molaire de composé hydroxyaromatique par rapport à l'ensemble des monomères constituants le polyamide, par exemple la somme des monomères diacide, diamine, aminoacides et le composé hydroxyaromatique, est généralement comprise entre 0,1 et 100 %, préférentiellement entre 1 et 70 %, plus préférentiellement entre 0,5 et 60 %, encore plus préférentiellement comprise entre 2,5 et 50 %.

Le polyamide de l'invention est notamment obtenu par un procédé de polymérisation à l'état fondu des différents monomères décrits ci-dessus, ces monomères étant présents en totalité ou en partie.

Par l'expression « polymérisation à l'état fondu » on entend que la polymérisation est réalisée à l'état liquide, et que le milieu de polymérisation ne contient pas de solvant autre que de l'eau, éventuellement. Le milieu de polymérisation peut par exemple être une solution aqueuse comprenant les monomères, ou un liquide comprenant les monomères. Avantageusement le milieu de polymérisation comprend de l'eau comme solvant. Cela facilite l'agitation du milieu, et donc son homogénéité. Le milieu de polymérisation peut également comprendre des additifs tels que des limiteurs de chaîne. Le polyamide modifié de l'invention est généralement obtenu par polycondensation entre les différents monomères, présents en totalité ou en partie, pour former des chaînes polyamides, avec formation du produit d'élimination, en particulier l'eau, dont une partie peut se vaporiser. Le polyamide modifié de l'invention est généralement obtenu, par chauffage à température et pression élevées, par exemple d'une solution aqueuse comprenant les monomères, ou d'un liquide comprenant les monomères, pour évaporer le produit d'élimination, en particulier l'eau (présente initialement dans le milieu de polymérisation et/ou formée lors de la polycondensation) tout en évitant toute formation de phase solide afin d'éviter une prise en masse.

La réaction de polycondensation est généralement effectuée à une pression comprise entre 0,5 et 3,5 MPa, préférentiellement entre 0,5 et 2,5 MPa ; à une température comprise entre 100 et 320°C, préférentiellement entre 180 et 300°C. La polycondensation est généralement poursuivie en phase fondue à pression atmosphérique ou réduite de manière à atteindre le degré d'avancement souhaité.

Le produit de polycondensation est un polymère ou prépolymère fondu. Il peut comprendre une phase vapeur essentiellement constituée de vapeur du produit d'élimination, en particulier d'eau, susceptible d'avoir été formée et/ou vaporisée.

Ce produit peut être soumis à des étapes de séparation de phase vapeur et de finition afin d'atteindre le degré de polycondensation désiré. La séparation de la phase vapeur peut par exemple être réalisée dans un dispositif de type cyclone. De tels dispositifs sont connus.

La finition consiste à maintenir le produit de polycondensation à l'état fondu, sous une pression voisine de la pression atmosphérique ou sous pression réduite, pendant un temps suffisant pour atteindre le degré d'avancement désiré. Une telle opération est connue de l'homme du métier. La température de l'étape de finition est avantageusement supérieure ou égale à 100°C et dans tous les cas supérieure à la température de solidification du polymère. Le temps de séjour dans le dispositif de finition est de préférence supérieur ou égal à 5 minutes.

Le produit de polycondensation peut également subir une étape de post-condensation en phase solide. Cette étape est connue de l'homme du métier et permet d'augmenter le degré de polycondensation à une valeur souhaitée.

Le procédé de l'invention est similaire dans ses conditions au procédé classique de préparation de polyamide du type de ceux obtenus à partir d'acides dicarboxyliques et de diamines, en particulier du procédé de fabrication de polyamide 66 à partir d'acide adipique et d'hexaméthylène diamine et des polyphtalamides. Ce procédé de fabrication de polyamide 66 est connu de l'homme du métier. Le procédé de fabrication de polyamide du type de ceux obtenus à partir d'acides dicarboxyliques et de diamines utilise généralement comme matière première, un sel obtenu par un mélange en quantité stoechiométrique en général dans un solvant comme l'eau, d'un diacide avec une diamine. Ainsi, dans la fabrication du poly(hexaméthylène adipamide), l'acide adipique est mélangé avec de l'hexaméthylène diamine généralement dans de l'eau pour obtenir de l'adipate d'hexaméthylène diammonium plus connu sous le nom de sel Nylon ou "Sel N".

Ainsi, lorsque le procédé de l'invention met en oeuvre un diacide et une diamine, ces composés peuvent être introduits, au moins en partie, sous la forme d'un sel. En particulier lorsque le diacide est l'acide adipique et la diamine l'hexaméthylène diamine, ces composés peuvent être introduits au moins en partie sous forme de sel N. Ceci permet d'avoir un équilibre stoechiométrique. De même lorsque le composé hydroxyaromatique est un diacide ou une diamine, il est également possible de l'introduire sous forme de sels, avec une diamine ou un diacide.

Le procédé de l'invention conduit généralement à un polymère statistique lorsque le composé hydroxyaromatique est polyfonctionnel, notamment au moins difonctionnel, et à un polyamide ayant partiellement ou totalement des terminaisons hydroxyaromatique, lorsque le composé hydroxyaromatique est monofonctionnel.

Le polyamide modifié obtenu à la fin de l'étape de finition peut être refroidi et mis sous forme de granulés.

Le polyamide modifié selon l'invention peut être utilisé en tant que matrice, seul ou en combinaison avec d'autres polymères thermoplastiques, notamment des polyamides, polyesters, ou polyoléfines.

La composition selon l'invention comprend des charges de renfort ou de remplissages, comme par exemple des charges fibreuses et/ou des charges non fibreuses.

Comme charges fibreuses on peut citer les fibres de verre, les fibres de carbone, les fibres naturelles, les fibres d'aramides, et les nanotubes, notamment de carbone. On peut citer comme fibres naturelles le chanvre et le lin. Parmi les charges non fibreuses on peut notamment citer toutes les charges particulaires, lamellaires et/ou les nanocharges exfoliables ou non exfoliables comme l'alumine, le noir de carbone, les argiles alumino-silicates, les montmorillonites, le phosphate de zirconium, le kaolin, le carbonate de calcium, les diatomées, le graphite, le mica, la silice, le dioxyde de titane, les zéolites, le talc, la wollastonite, les charges polymériques telles que, par exemple, des particules de diméthacrylates, les billes de verre ou de la poudre de verre.

Il est parfaitement possible selon l'invention que la composition comprenne plusieurs types de charges de renfort. De façon préférentielle, la charge la plus utilisée peut être les fibres de verres, du type dit coupé (chopped), notamment ayant un diamètre compris entre 7 et 14 µm. Ces charges peuvent présenter un ensimage surfacique qui assure l'adhésion mécanique entre les fibres et la matrice polyamide.

La concentration pondérale des charges de renfort ou de remplissage est comprise avantageusement entre 1 % et 60 % en poids par rapport au poids total de la composition, de préférence entre 15 et 50 %.

La composition selon l'invention peut comprendre tout type d'agents ignifugeants, c'est à dire des composés permettant de diminuer la propagation de la flamme et/ou ayant des propriétés d'ignifugation, bien connus de l'homme du métier. Ces agents ignifugeants sont habituellement utilisés dans des compositions ignifugées et sont notamment décrits, par exemple, dans les brevets US6344158, US6365071, US6211402 et US6255371, cités ici à titre de référence.

L'agent ignifugeant est choisi parmi le groupe comprenant :
* les agents ignifugeants contenant du phosphore, tels que :
   - les oxydes de phosphines comme par exemple l'oxyde de triphénylphosphine, l'oxyde de tri-(3-hydroxypropyl) phosphine et l'oxyde de tri-(3-hydroxy-2-méthylpropyl) phosphine.
   - les acides phosphoniques ou leurs sels ou les acides phosphiniques ou leurs sels, tels que par exemple les sels d'acides phosphiniques de zinc, de magnésium, de calcium, d'aluminium, ou de manganèse, notamment le sel d'aluminium de l'acide diéthylphosphinique ou le sel de zinc de l'acide diméthylphosphinique.
   - les phosphonates cycliques, tels que les esters de diphosphate cyclique tel que par exemple l'Antiblaze 1045.
   - les phosphates organiques, tels que le triphénylphosphate.
   - les phosphates inorganiques, tels que les polyphosphates d'ammonium et les polyphosphates de sodium.
   - le phosphore rouge, qu'il soit par exemple sous forme stabilisé ou revêtu, en poudre ou sous forme de masterbatches.
* les agents ignifugeants de type composés organiques azotés tels que par exemple les triazines, l'acide cyanurique et/ou isocyanurique, la mélamine ou ses dérivés comme le cyanurate de mélamine, l'oxalate, le phtalate, le borate, le sulfate, le phosphate, polyphosphate et/ou pyrophosphate de mélamine, les produits condensés de la mélamine, tel que la mélem, la mélam et le mélon, le tris(hydroxyéthyl) isocyanurate, la benzoguanamine, la guanidine, l'allantoïne, et le glycoluril.
* les agents ignifugeants contenant des dérivés halogénés, tels que :
   - les dérivés du brome tels que par exemple les PBDPO (polybromodiphényloxydes), le BrPS (polystyrène bromé et polybromostyrène), le poly(pentabromobenzylacrylate), l'indane bromé, le tétradécabromodiphénoxybenzène (Saytex 120), l'éthane-1,2-bis(pentabromophényl) ou Saytex 8010 d'Albemarle, le tétrabromobisphénol A et les oligomères époxy bromés. Notamment parmi les dérivés bromés, nous pouvons citer le polydibromostyrène tel que le PDBS-80 de Chemtura, les polystyrènes bromés tels que le Saytex HP 3010 d'Albemarle ou le FR-803P de Dea Sea Bromine Group, le décabromodiphényléther (DBPE) ou FR-1210 de Dea Sea Bromine Group, l'octabromodiphényléther (OBPE), le 2,4,6-Tris(2,4,6-tribromophénoxy)-1,3,5 triazine ou FR-245 de Dead Sea Bromine Group, le Poly(pentabromobenzylacrylate) ou FR-1025 de Dead Sea Bromine Group et les oligomères ou polymères à terminaisons époxy du tétrabromobisphénol-A comme tels que les F-2300 et F2400 de Dead Sea Bromine Group.
   - les composés chlorés, tel que par exemple un composé cycloaliphatique chloré comme le Dechlorane plus® (vendu par OxyChem, voir CAS 13560-89-9).

Ces composés peuvent être utilisés seuls ou en combinaison, parfois synergique. On préfère notamment une association synergique de composés contenant du phosphore comme les oxydes de phosphines, les acides phosphoniques ou leurs sels ou les acides phosphiniques ou leurs sels, et les phosphonates cycliques ; avec des dérivés azotés tels que le mélam, le mélem, le phosphate de mélamine, les polyphosphates de mélamine, les pyrophosphates de mélamine ou les polyphosphates d'ammonium. On peut notamment utiliser comme agents synergiques les composés d'antimoine, les oxydes métalliques, et le borate de zinc.

La composition peut comprendre de 5 à 40 % en poids d'agents ignifugeants, par rapport au poids total de la composition.

La composition selon l'invention peut en outre comprendre des charges et/ou additifs classiquement utilisés pour la fabrication de compositions polyamides. Ainsi, on peut citer, les lubrifiants, les plastifiants, les agents nucléants, les agents modificateurs de chocs, les catalyseurs, les stabilisants lumières et/ou thermiques, les antioxydants, les antistatiques, les colorants, les matifiants, les additifs d'aide au moulage ou autres additifs conventionnels.

On peut notamment ajouter à la composition polyamide des agents modifiants la résistance aux chocs. Ce sont généralement des polymères d'élastomères qui peuvent être utilisés à cet effet. Les agents modificateurs de la résilience sont généralement définis comme ayant un module de traction ASTM D-638 inférieur à environ 500 MPa. Des exemples d'élastomères convenables sont les éthylène-ester acrylique-anhydride maléïque, les ethylène-propylène-anhydride maléïque, les ethylène-propylène-diène momonère (EPDM) avec éventuellement un anhydride maléïque greffé. La concentration pondérale en élastomère est avantageusement comprise entre 0,1 et 30 % par rapport au poids total de la composition.

On préfère notamment les agents modificateurs de chocs comprenant des groupements fonctionnels réactifs avec le polyamide. On peut par exemple citer les terpolymères d'éthylène, ester acrylique et glycidyl méthacrylate, les copolymères d'éthylène et de butyl ester acrylate, les copolymères d'éthylène, n-butyl acrylate et glycidyl méthacrylate, les copolymères d'éthylène et d'anhydride maléique, les copolymères styrène-maléïmides greffés avec de l'anhydride maléique, les copolymères styrène-éthylène-butylène-styrène modifié avec de l'anhydride maléique, les copolymère styrène-acrylonitrile greffés anhydrides maléiques, les copolymères acrylonitrile butadiène styrène greffés anhydrides maléiques, et leurs versions hydrogénées. La proportion en poids de ces agents dans la composition totale est notamment comprise entre 0,1 et 40 %.

Ces charges et additifs peuvent être ajoutés au polyamide modifié par des moyens usuels adaptés à chaque charge ou additif, tel que par exemple lors de la polymérisation ou en mélange en fondu.

Les matériaux et compositions de l'invention sont généralement obtenus par mélange des différents constituants à chaud, par exemple dans une extrudeuse mono ou bivis, à une température suffisante pour maintenir la résine polyamide en milieu fondu ; ou a froid dans un mélangeur mécanique notamment. Généralement, le mélange obtenu est extrudé sous forme de joncs qui sont coupés en morceaux pour former des granulés. Les composés peuvent être ajoutés à n'importe quel moment du processus de fabrication du matériau plastique, notamment par mélange à chaud ou à froid avec la matrice plastique. L'addition des composés et des additifs peut être réalisée par ajout de ces composés dans la matrice plastique fondue sous forme pure ou sous forme de mélange concentré dans une matrice telle que par exemple une matrice plastique.

La composition est préférentiellement une composition à mouler, par exemple sous forme de granulés ou de poudre, servant notamment à la fabrication d'articles par un procédé de moulage par injection. La composition selon l'invention peut être utilisée pour tout procédé de mise en forme des matières plastiques, tels que par exemple les procédés de moulage, notamment le moulage par injection, le rotomoulage, le frittage, la coulée, ou d'extrusion comme l'extrusion soufflage et le filmage. L'invention concerne ainsi aussi des procédés de fabrication d'articles moulés ou extrudés par mise en forme d'une composition de l'invention.

La présente invention concerne notamment aussi des articles de type composants montés en surface (CMS) obtenus par mise en forme de la composition selon l'invention. Ces articles sont généralement réalisés par un procédé de moulage par injection dans lequel on introduit dans un dispositif de moulage par injection une composition selon l'invention, notamment sous forme de granulés, et l'on procède au moulage.

La présente invention concerne également un procédé d'assemblage de composants montés en surface (CMS) tels que décrits précédemment par une technique de soudage et/ou brasage, comme notamment le soudage en phase vapeur, la soudure à la vague, la soudure au trempé, le soudage par refusion sous rayonnement infra-rouge, le soudage conventionnel sous air chaud. La présente invention concerne aussi un procédé d'assemblage de composants montés en surface (CMS) tels que décrits précédemment sur un support tel qu'une carte de circuit imprimé par un brasage par refusion utilisant une crème ou pâte à braser sans plomb.

Comme type de composants montés en surface on peut notamment citer les connecteurs électriques, tels que les connecteurs I/O (input/output), les connecteurs FCP (flat printed circuit), les connecteurs PCB (printed circuit board), les connecteurs FFC (flat flexible cable), et les connecteurs MID (moulded integrated device). Les surfaces peuvent notamment être un circuit imprimé ou une carte électronique, par exemple, comprenant généralement une face « composants » et une face « soudure ».

Un connecteur électrique comprend un ou plusieurs éléments conducteurs électriques enveloppés par un boîtier (« housing ») fait d'un matériau isolant électrique, comme un matériau plastique. Ce matériau plastique peut être une composition polymère et le boitier (« housing ») peut être obtenu par un moulage par injection.

Un langage spécifique est utilisé dans la description de manière à faciliter la compréhension du principe de l'invention. Il doit néanmoins être compris qu'aucune limitation de la portée de l'invention n'est envisagée par l'utilisation de ce langage spécifique. Des modifications, améliorations et perfectionnements peuvent notamment être envisagés par une personne au fait du domaine technique concerné sur la base de ses propres connaissances générales.

Le terme et/ou inclut les significations et, ou, ainsi que toutes les autres combinaisons possibles des éléments connectés à ce terme.

D'autres détails ou avantages de l'invention apparaîtront plus clairement au vu des exemples donnés ci-dessous uniquement à titre indicatif.

### PARTIE EXPERIMENTALE

### Caractérisations

Teneurs en groupements terminaux acide (GTC) et amine (GTA) : dosées par potentiométrie, exprimées en meq/kg. Teneur en groupement bloqueur de chaîne (GTB) calculée à partir des quantités initiales de réactifs. Par exemple, l'acide benzoïque ou l'acide acétique peuvent être utilisés comme bloqueurs de chaîne.

Masse molaire moyenne en nombre Mn déterminée par la formule Mn=2.10⁶/(GTA+GTC+GTB) et exprimée en g/mol.

Température de fusion (T_{f}) et enthalpie associée (ΔHf), température de cristallisation au refroidissement (T_{c}) : déterminées par calorimétrie différentielle à balayage (DSC « Differential Scanning Calorimetry »), à l'aide d'un appareil Perkin Elmer Pyris 1, à une vitesse de 10°C/min.

Température de transition vitreuse (T_{g}) déterminée sur le même appareil à une vitesse de 40 °C/min.

### Polymères utilisés :

### Préparation d'un PA 66 non modifié

Dans **un** réacteur de polymérisation sont introduits 92,6 kg (353 mol) de sel N (sel 1:1 d'hexaméthylène diamine et d'acide adipique), 84 kg d'eau déminéralisée et 6,4 g d'agent antimousse Silcolapse 5020®. Le polyamide 66 est fabriqué selon un procédé standard de polymérisation de type polyamide 66, avec 30 minutes de finition. Le polymère obtenu est coulé sous forme de jonc, refroidi et mis sous forme de granulé par coupe des joncs.

Le polymère obtenu présente les caractéristiques suivantes : GTC = 70,2 meq/kg, GTA = 51,5 meq/kg, Mn = 16430 g/mol. Le polyamide 66 est semi-cristallin et a les caractéristiques thermiques suivantes : Tg= 70,6 °C, Tc= 230,9 °C, Tf= 263,7 °C, ΔHf = 68,4 J/g.

### Préparation d'un copolyamide PA 66/6HIA 95/5 molaire ou 94,2/5,8 en poids

Dans un réacteur de polymérisation sont introduits 87,3 kg (332,8 mol) de sel N (sel 1:1 d'hexaméthylène diamine et d'acide adipique), 3219 g d'acide 5-hydroxyisophtalique à 99,5% (HIA) (17,5 mol), 6276 g d'une solution d'hexaméthylène diamine (HMD) en solution dans l'eau à 32,4 % en poids (17,5 mol) et 81,2 kg d'eau déminéralisée et 6,4 g d'agent anti-mousse Silcolapse 5020®. Le copolyamide est fabriqué selon un procédé standard de polymérisation de type polyamide 66, avec 35 minutes de finition. Le polymère obtenu est coulé sous forme de jonc, refroidi et mis sous forme de granulé par coupe des joncs.

Le polymère obtenu présente les caractéristiques suivantes : GTC = 78,4 meq/kg, GTA = 57,6 meq/kg, Mn = 14 700 g/mol. Le copolyamide est semi-cristallin et a les caractéristiques thermiques suivantes : Tg= 76,8 °C, Tc= 218,4 °C, Tf= 256,2 °C, ΔHf = 62,5 J/g. Le copolyamide a une Tg supérieure de 6,2 °C par rapport à celle du PA 66.

### Préparation d'un copolyamide PA 66/6HIA 85/15 molaire ou 83/17 en poids

Dans un réacteur de polymérisation sont introduits 76,9 kg (293,1 mol) de sel N (sel 1:1 d'hexaméthylène diamine et d'acide adipique), 9462 g d'acide 5-hydroxyisophtalique à 99,5% (HIA) (51,7 mol), 18624 g d'une solution d'hexaméthylène diamine (HMD) en solution dans l'eau à 32,25 % en poids (51,7 mol) et 72,6 kg d'eau déminéralisée et 6,4 g d'agent anti-mousse Silcolapse 5020®. Le copolyamide est fabriqué selon un procédé standard de polymérisation de type polyamide 66, avec 35 minutes de finition. Le polymère obtenu est coulé sous forme de jonc, refroidi et mis sous forme de granulé par coupe des joncs.

Le polymère obtenu présente les caractéristiques suivantes : GTC = 82,7 meq/kg, GTA = 61,5 meq/kg, Mn = 13 870 g/mol. Le copolyamide est semi-cristallin et a les caractéristiques thermiques suivantes : Tg= 85,8 °C, Tc= 186,2 °C, Tf= 240,4 °C, ΔHf = 41,9 J/g. Le copolyamide a une Tg supérieure de 15,2 °C par rapport à celle du PA 66.

### Préparation d'un polyamide PA 6HIA

Un sel 6HIA à 51% en poids dans l'eau est réalisé par mélange d'une quantité stoechiométrique d'hexaméthylène diamine et d'acide 5-hydroxyisophtalique dans l'eau. Dans un réacteur de polymérisation sont ensuite introduits 5623 g de sel 6HIA à 51%, 112,1 g d'acide 5-hydroxyisophtalique à 99,5%, 105 g d'eau et 3,3 g d'agent anti-mousse. Le polyamide PA 6HIA est fabriqué selon un procédé standard de polymérisation de type polyamide 66, avec 30 minutes de finition. Le polymère obtenu est coulé sous forme de jonc, refroidi et mis sous forme de granulé par coupe des joncs.

Le polymère obtenu est amorphe et présente une température de transition vitreuse de Tg= 166,6 °C.

### Préparation des mélanges PA 66 + PA 6HIA 94,2/5,8 et PA 66 + PA 6HIA 83/17 en poids

Avant mélange, le PA 66 et le PA 6HIA sont séchés de sorte à obtenir une teneur en eau inférieure à 1000 ppm dans les granulés. Le PA 66 et le PA 6HIA ainsi préparés sont mélangés dans une proportion 94,2/5,8 et 83/17 en poids en voie fondu dans une extrudeuse bi-vis bi-vis co-rotative WERNER&PLEIFEDER ZSK40 W325 fonctionnant à un débit de 40 kg/h à une vitesse de vis de 270 trs/min et avec une pression réduite à 0,9 bar. Les températures de consigne des 8 zones sont respectivement : 245, 255, 255, 255, 255, 260, 260, 270°C. Tous les composants de la formulation sont introduits au début de l'extrudeuse.

### Préparation d'un polyamide PA 66/6T/6HIA 49/41/10 molaire

Dans un réacteur de polymérisation sont introduits 43,12 kg de sel N (164,36 mol), 38,82 kg d'un sel 6T (sel 1:1 d'hexaméthylène diamine et d'acide téréphtalique) (137,50 mol), 6,14 kg d'acide 5-hydroxyisophtalique à 99,5 % (HIA) (33,5 mol), 13kg d'une solution d'hexaméthylène diamine (HMD) en solution dans l'eau à 32,50 % en poids (36,36 mol), 699,5 g d'acide benzoïque à 99% (5,67 mol) et 77,1 kg d'eau déminéralisée et 6,4 g d'un agent anti-mousse Silcolapse 5020. Le copolyamide est fabriqué selon un procédé standard de polymérisation de type polyamide 66 à une température finale de 290 °C et 15 minutes de finition. Le polymère obtenu est coulé sous forme de jonc, refroidi et mis sous forme de granulé par coupe des joncs.

Le polymère obtenu présente les caractéristiques suivantes : GTC = 86,7 meq/kg, GTA = 45,7 meq/kg, GTB= 71 meq/kg, Mn = 9830 g/mol. Le polyamide PA 66/6T/6HIA 49/41/10 est semi-cristallin et a les caractéristiques thermiques suivantes : Tg= 103,8 °C, Tc= 253,4 °C, Tf= 279,7 °C, ΔHf = 45,7 J/g. Ce polymère de haute température de fusion est utilisé pour la préparation de formulation destinée à la fabrication de connecteurs.

### Préparation de formulations comprenant des fibres de verre

Des formulations de polyamides contenant 30% en poids de fibres de verre sont réalisées par mélange en voie fondu dans une extrudeuse bi-vis co-rotative WERNER&PLEIFEDER ZSK40 W325 fonctionnant à un débit de 40 kg/h à une vitesse de vis de 270 trs/min et avec une pression réduite à 0,9 bar. Les températures de consigne des 8 zones sont respectivement : 245, 255, 255, 255, 255, 260, 260, 270°C. Tous les composants de la formulation sont introduits au début de l'extrudeuse. Pour certains essais, de la résine novolaque a également été ajoutée à l'extrudeuse.

### Exemple 1: Injection et test de stabilité dimensionnelle en environnement humide

Les polyamides et les formulations GF30 sont séchés à une teneur en eau inférieure à 1000 ppm avant d'être enrobées d'ethylène bis stearamide (EBS) ajouté à hauteur de 0,25% en poids. Les polyamides et formulations GF30 lubrifiés externe sont ensuite injectées sous la forme de plaques 100x100x2 mm3 sur une presse à injecter DEMAG 80t, avec les paramètres suivants : température moule réglée à 80°C, températures du fourreau 275/280/285/290°C pour le PA 66 GF30 et 265/275/275/280°C pour les copolyamide PA 66/6HIA 85/15 GF30 et mélange PA 66 + PA 6HIA 83/17 GF30, temps de cycle de 25 s.

Les plaques sont placées dans une enceinte climatique régulée à 70°C et humidité relative HR de 62% jusqu'à ce que la reprise en eau à saturation soit obtenue (atteinte au bout de 264 h). Des mesures de variation dimensionnelle en milieu humide dans les sens parallèle (∥) et perpendiculaire (⊥) au sens d'injection ont été effectuées sur ces mêmes plaques avant et après conditionnement pendant 264h à HR62 70°C.

Les résultats de variation dimensionnelle en milieu humide sont rassemblés dans le tableau suivant. A titre d'exemple, nous avons donnée les valeurs de variation dimensionnelle de mélanges PA 66 + résine novoloque dont la teneur en motifs phénol par rapport aux motifs amides est similaire à celle d'un copolyamide PA 66/6HIA 85/15 mol/mol ou d'un mélange PA 66 + PA 6 HIA 83/17 poids/poids.

**Tableau 1**

| **Formulation** | **Type** | **Variation dimensionnelle (∥)** | **Variation dimensionnelle (⊥)** |
|---|---|---|---|
| C1 | PA 66 | 0,33 | 0,36 |
| C2 | PA 66/6HIA 95/5 mol | 0,23 | 0,23 |
| C3 | PA 66/6HIA 85/15 mol | 0,51 | 0,51 |
| C4 | PA 66/PA 6 6HIA 94,2/5,8 poids | 0,10 | 0,13 |
| C5 | PA 66/PA 6HIA 83/17 poids | 0,10 | 0,30 |
| C6 | PA 66 + 7% pds novolaque | 0,14 | 0,13 |
| C7 | PA 66 GF30 | 0,15 | 0,30 |
| C8 | PA 66 + 7% pds novolaque GF30 | 0,15 | 0,22 |
| **1** | PA 66/6HIA 85/15 mol GF30 | 0,06 | 0,05 |
| **2** | PA 66/PA 6HIA 83/17 poids GF30 | 0,15 | 0,12 |

Nous avons observé de manière tout a fait surprenante que le copolyamide PA 66/6HIA 85/15 a une stabilité dimensionnelle inférieure à celle du PA 66 mais que sur des formulations contenant 30% de fibres de verre, le PA 66/6HIA 85/15 GF30 présente la meilleure stabilité dimensionnelle, signe d'une forte adhésion du polyamide portant des fonctions hydroxy-aromatiques sur les fibres de verre.

### Exemple 2: préparation d'une formulation ignifugée à partir de du polyamide PA 66/6T/6HIA 49/41/10

Avant d'être formulé, le PA 66/6T/6HIA 49/41/10 est séché à 90°C, une suit sous vide avec un léger flux d'azote, de façon à obtenir une teneur en eau inférieure à 1000 ppm. Il est ensuite mélangé en voie fondu dans une extrudeuse bi-vis co-rotative (diamètre interne de 30 mm et L/D=30) avec des fibres de verre type 301X1 de la société CPIC (30% en poids), un agent ignifugeant sel d'aluminium de l'acide diéthylephosphinique Exolit OP1230 de la société Clariant (18% en poids), un mélange de stabilisant thermique et de lubrifiant (0,5% en poids). Les températures du fourreau de l'extrudeuse sont réglées entre 270-290°C, la vitesse des vis est de 250 trs/min sous un vide de 50-70 cmHg, le débit est de 25-30kg/h dans ces conditions.

Cette formulation est injectée sur une presse à injecter ENGEL 80t avec une température de fourreau réglée à 290°C dans un moule régulé à environ 90°C. Le test UL 94 réalisé sur des éprouvettes type UL d'épaisseur 0,8 mm indique une cotation V0. Les propriétés mécaniques indiquent une contrainte en traction à la rupture de 152 MPa et une élongation à la rupture de 2,1%. La contrainte en flexion est de 247 MPa et le module en flexion de 10550 MPa. La résistance à l'impact est évaluée par un test Charpy non entaillé : 67 kJ/m2.

Cette formulation est soumise à un test de résistance au blistering par introduction d'une éprouvette type UL 0,8 mm injectée précédemment (dimensions 127x12,7x0,8 mm3) dans une machine Seho FDS Maxipower selon un procédé standard de reflow soldering avec une température au pic de 247°C (première étape: chauffe de 30°C à 120°C à 2,8°C/s, deuxième étape: chauffage de 120°C à 190°C à 0,5°C/s, troisième étape : chauffage de 190°C à 247°C à 0,85°C/s, quatrième étape : isotherme à 247°C pendant 5 s, cinquième étape : refroidissement rapide à -3°C/s jusqu'à température ambiante). Elle ne présente aucun signe de blistering.

Pour comparaison, une formulation d'un PA 66/6T 65/35 molaire (de température de fusion identique à celle du PA 66/6T/6HIA 49/41/10) GF30 contenant 18% en poids un agent ignifugeant sel d'aluminium de l'acide diéthylephosphinique Exolit OP1230 de la société Clariant, 0,5% en poids d'un mélange de stabilisant thermique et de lubrifiant et 4% en poids d'une résine novolaque Durez de Sumitomo Bakelite Co., Ltd. Group a été étudiée. Le test UL 0,8 mm indique une cotation V0, mais le test de résistance au blistering avec une température au pic de 247°C montre la présence de blistering, c'est-à-dire des cloques ou bulles formées à la surface en contact avec l'air chaud, réparties de manière homogène sur toute la surface en contact avec la source de chaleur et de diamètre compris entre 1 mm et 10 mm

## Revendications

1. Composant destiné à être monté en surface au moins obtenu à partir d'une composition comprenant au moins A) un polyamide semi-aromatique modifié par un composé hydroxyle aromatique ; B) des charges de renfort ; et C) un agent ignifugeant
• ledit polyamide semi-aroznatique modifié par un composé hydroxyle aromatique étant un polyamide obtenu en utilisant des monomères aliphatiques ainsi que des monomères aromatiques, et en outre un composé hydroxyle aromatique, et
• ledit agent ignifugeant étant choisi parmi le groupe comprenant les agents ignifugeants contenant du phosphore, les agents ignifugeants de type composés organiques azotés, les agents ignifugeants contenant des dérivés halogénés.

2. Composant selon la revendication 1 dans lequel 5-50 % en moles des monomères utilisés dans ledit polyamide semi-aromatique sont des monomères comprenant des groupements aromatiques, incluant les composés hydroxyles aromatiques.

3. Composant selon la revendication 1 ou 2, **caractérisé en ce que** ledit polyamide est choisi dans le groupe comprenant : le polyamide 6T, le polyamide 66/6T, le polyamide 61, le polyamide 66/61, le polyamide 6T/6I, le copolyamide 6/6T de différentes compositions molaires ainsi que leurs mélanges.

4. Composant selon l'une quelconque des revendications 1 à 3, **caractérisé en ce que** ledit polyamide présente un point de fusion compris entre 150°C et 340°C.

5. Composant selon l'une quelconque des revendications 1 à 4, **caractérisé en ce que** la composition comprend de 30 à 75 % en poids de polyamide, par rapport au poids total de la composition.

6. Composant selon l'une quelconque des revendications 1 à 5, **caractérisé en ce que** le composé hydroxyle aromatique présente au moins une fonction capable de réagir avec les fonctions du polyamide ou des monomères du polyamide.

7. Composant selon l'une quelconque des revendications 1 à 6, **caractérisé en ce que** le composé hydroxyle aromatique est représenté par la formule suivante (I):
**(HO)ₓ-Z-(F)ₙ** **(I)**
dans laquelle :
- Z est un radical hydrocarboné aromatique ou arylaliphatique multivalent, ledit radical arylaliphatique est un radical selon lequel au moins une fonction F du composé de formule (I) n'est pas rattaché à ce radical par un atome de carbone faisant partie d'un cycle aromatique ;
- x est compris entre 1 et 10 ;
- F est une fonction acide, aldéhyde, amine, cétone capable de se lier à une fonction acide ou amine des monomères du polyamide ; et
- n est compris entre 1 et 5.

8. Composant selon la revendication 7, **caractérisé en ce que** Z est un radical multivalent est choisi dans le groupe comprenant : le benzène, le méthyle benzène, le naphtalène, le biphényle, le diphényle éther, le diphényle sulfure, le diphényle sulfone, le ditolyle éther, le xylylène, le diéthyl benzène, ou la pyridine.

9. Composant selon l'une quelconque des revendications 1 à 8, **caractérisé en ce que** le composé hydroxyle aromatique est choisi dans le groupe comprenant : l'acide 2-hydroxytéréphtalique, l'acide 5-hydroxyisophtalique, l'acide 4-hydroxyisophtalique, l'acide 2,5-dihydroxytéréphtalique, l'acide 4-hydroxyphénylacétique ou l'acide gallique, la L-tyrosine, l'acide 4-hydroxyphénylacétique, le 3,5-diaminophénol, le 5-hydroxy m-xylylène diamine, l'amino-3 phénol, l'amino-3 méthyl-4 phénol, et l'acide hydroxy-3 amino-5 benzoïque.

10. Composant selon l'une quelconque des revendications 1 à 9, **caractérisé en ce que** les charges de renfort sont des charges fibreuses choisis dans le groupe comprenant les fibres de verre, les fibres de carbone, les fibres naturelles, les fibres d'aramides, les nanotubes, le chanvre et le lin.

11. Composant selon l'une quelconque des revendications 1 à 10, **caractérisé en ce que** la composition comprend de 15 à 50 % en poids de charge de renfort, par rapport au poids total de la composition.

12. Composant selon l'une quelconque des revendications 1 à 11, **caractérisé en ce que** l'agent ignifugeant contient du phosphore et est choisi dans le groupe constitué par : les oxydes de phosphines, les acides phosphoniques ou leurs sels, les acides phosphiniques ou leurs sels, les phosphonates cycliques, les phosphates organiques, les phosphates inorganiques, et le phosphore rouge.

13. Composant selon l'une quelconque des revendications 1 à 11, **caractérisé en ce que** l'agent ignifugeant est un agent ignifugeant de type composé organique azoté choisis dans le groupe constitué par : les triazines, l'acide cyanurique et/ou isocyanurique, la mélamine ou ses dérivés, l'oxalate, le phtalate, le borate, le sulfate, le phosphate, polyphosphate et/ou pyrophosphate de mélamine, les produits condensés de la mélamine, le tris(hydroxyéthyl) isocyanurate, la benzoguanamine, la guanidine, l'allantoïne, et le glycoluril.

14. Composant selon l'une quelconque des revendications 1 à 11, **caractérisé en ce que** l'agent ignifugeant est un agent ignifugeant contenant des dérivés bromés choisis dans le groupe constitué par : les PBDPO (polybromodiphényloxydes), le BrPS (polystyrène bromé et polybromostyrène), le poly(pentabromobenzylacrylate), l'indane bromé, le tétradécabromodiphénoxybenzène, l'éthane-1,2-bis(pentabromophényl), le tétrabromobisphénol A et les oligomères époxy bromés.

15. Composant selon l'une quelconque des revendications 1 à 14, **caractérisé en ce que** la composition comprend de 5 à 40 % en poids d'agents ignifugeants, par rapport au poids total de la composition.

16. Procédé d'assemblage d'un composant tel que décrit selon l'une quelconque des revendications 1 à 15 sur une surface par une technique de soudage et/ou brasage.

## Patentansprüche

1. Bauteil für Oberflächenmontage, mindestens erhalten aus einer Zusammensetzung, umfassend mindestens A) ein durch eine aromatische Hydroxylverbindung modifiziertes teilaromatisches Polyamid; B) verstärkende Füllstoffe und C) ein Flammschutzmittel;
• wobei es sich bei dem durch eine aromatische Hydroxylverbindung modifizierten teilaromatischen Polyamid um ein durch Verwendung von aliphatischen Monomeren sowie aromatischen Monomeren und außerdem einer aromatischen Hydroxylverbindung erhaltenes Polyamid handelt und
• wobei das Flammschutzmittel aus der Gruppe umfassend phosphorhaltige Flammschutzmittel, Flammschutzmittel vom Typ organische Stickstoffverbindungen und halogenierte Derivate enthaltende Flammschutzmittel ausgewählt ist.

2. Bauteil nach Anspruch 1, wobei es sich bei 5-50 Mol-% der in dem teilaromatischen Polyamid verwendeten Monomere um Monomere mit aromatischen Gruppen einschließlich aromatischer Hydroxylverbindungen handelt.

3. Bauteil nach Anspruch 1 oder 2, **dadurch gekennzeichnet, dass** das Polyamid aus der Gruppe umfassend Polyamid 6T, Polyamid 66/6T, Polyamid 61, Polyamid 66/61, Polyamid 6T/6I und Copolyamid 6/6T verschiedener molarer Zusammensetzungen sowie Mischungen davon ausgewählt ist.

4. Bauteil nach einem der Ansprüche 1 bis 3, **dadurch gekennzeichnet, dass** das Polyamid einen Schmelzpunkt zwischen 150°C und 340°C aufweist.

5. Bauteil nach einem der Ansprüche 1 bis 4, **dadurch gekennzeichnet, dass** die Zusammensetzung 30 bis 75 Gew.-% Polyamid, bezogen auf das Gesamtgewicht der Zusammensetzung, umfasst.

6. Bauteil nach einem der Ansprüche 1 bis 5, **dadurch gekennzeichnet, dass** die aromatische Hydroxylverbindung mindestens eine Funktion aufweist, die mit den Funktionen des Polyamids oder der Monomere des Polyamids reagieren kann.

7. Bauteil nach einem der Ansprüche 1 bis 6, **dadurch gekennzeichnet, dass** die aromatische Hydroxylverbindung durch die folgende Formel (I) wiedergegeben wird:
**(HO)ₓ-Z-(F)ₙ** **(I)**
wobei:
- Z für einen mehrwertigen aromatischen oder arylaliphatischen Kohlenwasserstoffrest steht, wobei sich bei dem arylaliphatischen Rest um einen Rest handelt, gemäß dem mindestens eine Funktion F der Verbindung der Formel (I) nicht über ein Kohlenstoffatom, das Teil eines aromatischen Rings ist, an diesen Rest gebunden ist;
- x zwischen 1 und 10 liegt;
- F für eine Säure-, Aldehyd-, Amin- oder Ketonfunktion steht, die an eine Säure- oder Aminfunktion der Monomere des Polyamids binden kann; und
- n zwischen 1 und 5 liegt.

8. Bauteil nach Anspruch 7, **dadurch gekennzeichnet, dass** Z für einen mehrwertigen Rest aus der Gruppe umfassend Benzol, Methylbenzol, Naphthalin, Biphenyl, Diphenylether, Diphenylsulfid, Diphenylsulfon, Ditolylether, Xylylen, Diethylbenzol oder Pyridin steht.

9. Bauteil nach einem der Ansprüche 1 bis 8, **dadurch gekennzeichnet, dass** die aromatische Hydroxylverbindung aus der Gruppe umfassend 2-Hydroxyterephthalsäure, 5-Hydroxyisophthalsäure, 4-Hydroxyisophthalsäure, 2,5-Dihydroxyterephthalsäure, 4-Hydroxyphenylessigsäure oder Gallussäure, L-Tyrosin, 4-Hydroxyphenylessigsäure, 3,5-Diaminophenol, 5-Hydroxy-m-xylylendiamin, 3-Aminophenol, 3-Amino-4-methylphenol und 3-Hydroxy-5-aminobenzoesäure ausgewählt ist.

10. Bauteil nach einem der Ansprüche 1 bis 9, **dadurch gekennzeichnet, dass** es sich bei den verstärkenden Füllstoffen um faserförmige Füllstoffe ausgewählt aus der Gruppe umfassend Glasfasern, Kohlefasern, Naturfasern, Aramidfasern, Nanoröhren, Hanf und Flachs handelt.

11. Bauteil nach einem der Ansprüche 1 bis 10, **dadurch gekennzeichnet, dass** die Zusammensetzung 15 bis 50 Gew.-% verstärkenden Füllstoff, bezogen auf das Gesamtgewicht der Zusammensetzung, umfasst.

12. Bauteil nach einem der Ansprüche 1 bis 11, **dadurch gekennzeichnet, dass** das Flammschutzmittel Phosphor enthält und aus der Gruppe bestehend aus Phosphinoxiden, Phosphonsäuren oder Salzen davon, Phosphinsäuren oder Salzen davon, cyclischen Phosphonaten, organischen Phosphaten, anorganischen Phosphaten und rotem Phosphor ausgewählt ist.

13. Bauteil nach einem der Ansprüche 1 bis 11, **dadurch gekennzeichnet, dass** es sich bei dem Flammschutzmittel um ein Flammschutzmittel vom Typ organische Stickstoffverbindung ausgewählt aus der Gruppe bestehend aus Triazinen, Cyanursäure und/oder Isocyanursäure, Melamin oder Derivaten davon, Melaminoxalat, -phthalat, -borat, -sulfat, -phosphat, -polyphosphat und/oder -pyrophosphat, Kondensationsprodukten von Melamin, Tris(hydroxyethyl) isocyanurat, Benzoguanamin, Guanidin, Allantoin und Glykoluril handelt.

14. Bauteil nach einem der Ansprüche 1 bis 11, **dadurch gekennzeichnet, dass** es sich bei dem Flammschutzmittel um ein bromierte Derivate enthaltendes Flammschutzmittel ausgewählt aus der Gruppe bestehend aus PBDPO (Polybromdiphenyloxide), BrPS (bromiertes Polystyrol und Polybromstyrol), Poly(pentabrombenzylacrylat), bromiertem Indan, Tetradecabromdiphenoxybenzol, 1,2-Bis(pentabromphenyl)ethan, Tetrabrombisphenol A und bromierten Epoxidoligomeren handelt.

15. Zusammensetzung nach einem der Ansprüche 1 bis 14, **dadurch gekennzeichnet, dass** die Zusammensetzung 5 bis 40 Gew.-% Flammschutzmittel, bezogen auf das Gesamtgewicht der Zusammensetzung, umfasst.

16. Verfahren zum Montieren eines Bauteils gemäß einem der Ansprüche 1 bis 15 auf einer Oberfläche durch eine Schweiß- und/oder Löttechnik.

## Claims

1. Component intended for surface mounting obtained at least from a composition comprising at least A) a semiaromatic polyamide modified by an aromatic hydroxyl compound; B) reinforcing fillers; and C) a flame retardant
• said semiaromatic polyamide modified by an aromatic hydroxyl compound being a polyamide obtained by using aliphatic monomers and aromatic monomers together with an aromatic hydroxyl compound, and
• said flame retardant being selected from the group comprising flame retardants containing phosphorus, flame retardants of the organic nitrogen-containing compound type, flame retardants containing halogenated derivatives.

2. Component according to Claim 1, wherein 5-50 mol% of the monomers used in said semiaromatic polyamide are monomers comprising aromatic groups, including the aromatic hydroxyl compounds.

3. Component according to Claim 1 or 2, **characterized in that** said polyamide is selected from the group consisting of: polyamide 6T, polyamide 66/6T, polyamide 61, polyamide 66/61, polyamide 6T/6I, copolyamide 6/6T of differing molar compositions and blends thereof.

4. Component according to any one of Claims 1 to 3, **characterized in that** said polyamide has a melting point of between 150°C and 340°C.

5. Component according to any one of Claims 1 to 4, **characterized in that** the composition comprises 30% to 75% by weight of polyamide, with respect to the total weight of the composition.

6. Component according to any one of Claims 1 to 5, **characterized in that** the aromatic hydroxyl compound has at least one function that is capable of reacting with the functions of the polyamide or the polyamide monomers.

7. Component according to any one of Claims 1 to 6, **characterized in that** the aromatic hydroxyl compound is represented by the following formula (I):
**(HO)ₓ-Z-(F)ₙ** **(I)**
wherein:
- Z is a multivalent aromatic or arylaliphatic hydrocarbon radical, said arylaliphatic radical is a radical according to which at least one function F of the compound of formula (I) is not bonded to this radical by a carbon atom that is part of an aromatic ring;
- x is between 1 and 10;
- F is an acid, aldehyde, amine or ketone function that is capable of bonding to an acid or amine function of the polyamide monomers; and
- n is between 1 and 5.

8. Component according to Claim 7, **characterized in that** Z is a multivalent radical selected from the group consisting of: benzene, methylbenzene, naphthalene, biphenyl, diphenyl ether, diphenyl sulphide, diphenyl sulphone, ditolyl ether, xylylene, diethylbenzene or pyridine.

9. Component according to any one of Claims 1 to 8, **characterized in that** the aromatic hydroxyl compound is selected from the group consisting of: 2-hydroxyterephthalic acid, 5-hydroxyisophthalic acid, 4-hydroxyisophthalic acid, 2,5-dihydroxyterephthalic acid, 4-hydroxyphenylacetic acid or gallic acid, L-tyrosine, 4-hydroxyphenylacetic acid, 3,5-diaminophenol, 5-hydroxy-m-xylylenediamine, 3-aminophenol, 3-amino-4-methylphenol and 3-hydroxy-5-aminobenzoic acid.

10. Component according to any one of Claims 1 to 9, **characterized in that** the reinforcing fillers are fibrous fillers selected from the group consisting of glass fibres, carbon fibres, natural fibres, aramid fibres, nanotubes, hemp and flax.

11. Component according to any one of Claims 1 to 10, **characterized in that** the composition comprises 15% to 50% by weight of reinforcing filler, with respect to the total weight of the composition.

12. Component according to any one of Claims 1 to 11, **characterized in that** the flame retardant contains phosphorus and is selected from the group consisting of: phosphine oxides, phosphonic acids or salts thereof, phosphinic acids or salts thereof, cyclic phosphonates, organic phosphates, inorganic phosphates, and red phosphorus.

13. Component according to any one of Claims 1 to 11, **characterized in that** the flame retardant is a flame retardant of the organic nitrogen-containing compound type selected from the group consisting of: triazines, cyanuric and/or isocyanuric acid, melamine or derivatives thereof, melamine oxalate, phthalate, borate, sulphate, phosphate, polyphosphate and/or pyrophosphate, condensed melamine products, tris(hydroxyethyl) isocyanurate, benzoguanamine, guanidine, allantoin, and glycoluril.

14. Component according to any one of Claims 1 to 11, **characterized in that** the flame retardant is a flame retardant containing brominated derivatives selected from the group consisting of: PBDPOs (polybromodiphenyl oxides), BrPS (brominated polystyrene and polybromostyrene), poly(pentabromobenzyl acrylate), brominated indane, tetradecabromodiphenoxybenzene, 1,2-bis(pentabromophenyl)ethane, tetrabromobisphenol A and brominated epoxy oligomers.

15. Component according to any one of Claims 1 to 14, **characterized in that** the composition comprises 5% to 40% by weight of flame retardants, with respect to the total weight of the composition.

16. Process for assembling a component as described and according to any one of Claims 1 to 15 on a surface by means of a soldering and/or brazing technique.
